# FASCICULE DE BREVET EUROPEEN

(11) **EP 0 570 250 B1**
(45) Date de publication et mention de la délivrance du brevet: **03.06.1998**
(21) Numéro de dépôt: 93401047.1
(22) Date de dépôt: 22.04.1993
(51) Int. Cl.: C30B 29/54, G02F 1/35, C30B 7/00

(54) **Structure cristalline de monohydrogénotartrates, procédé de sa préparation et son application**
Kristalline Struktur aus Monohydrogentartraten, Verfahren zu ihrer Herstellung und ihre Anwendung
Crystalline structure of monohydrogentartrates, process for its preparation and application thereof

(30) Priorité: 24.04.1992 FR 9205077
(43) Date de publication de la demande: 18.11.1993
(73) Titulaire: FRANCE TELECOM, 75015 Paris (FR); CENTRE NATIONAL DE LA RECHERCHE SCIENTIFIQUE (CNRS), 75794 Paris Cédex 16 (FR)
(72) Inventeur: Zyss, Joseph, F-92330 Sceaux (FR); Hierle, Roland, F-75013 Paris (FR); Masse, René, Cidex 272F, Crolles, F-38190 Brignoud (FR); Levy, Jean-Pierre, F-38100 Grenoble (FR)
(74) Mandataire: Martin, Jean-Jacques

(56) Documents cités:
- WO-A-91/16657
- MOLECULAR ENGINEERING, vol. 1, 1991 DORDRECHT NL, pages 141-152, MASSE 'a new approach in the design of polar crystals for quadratic nonlinear optics'
- JP. JOURNAL OF APP. PHYSICS, vol. 29, no. 6, Juin 1990 TOKYO JP, pages 1112-1115, OKADA 'synthesis and crystal structure of novel...'
- MOLECULAR CRYSTALS AND LIQUID CRYSTALS (INC NONLINEAR CRYSTALS), vol. 182a, Mai 1990 READING GB, pages 51-57, UEMIYA ET AL 'crystal growth and characterisation of...'

## Description

La présente invention concerne de nouvelles structures cristallines présentant des effets non linéaires quadratiques et une plage de transparence large s'étendant du visible au proche infrarouge. Elle concerne également un procédé de préparation de ces structures cristallines et un dispositif à effet électrooptique comportant une telle structure cristalline.

La structure non centrosymétrique du cristal lui confère un tenseur de susceptibilité non-linéaire quadratique χ⁽²⁾ exploitable dans toute configuration de mélange à trois ondes de type "tout-optique" (génération de second-harmonique, conversion de fréquences, effets paramétriques) et électrooptique (effet Pockels). Le coefficient non-linéaire le plus élevé est orienté le long des dipoles moléculaires parallèles entre eux dans la maille cristalline.

La recherche de structures cristallines présentant des effets non linéaires quadratiques accrus par rapport aux matériaux tels que le dihydrogéno-phosphate de potassium (Okada et al. Jap. J. Appl. Phys. 16, 55, 1977) ainsi qu'une plage de transparence large s'étendant du visible au proche infrarouge s'est orientée au cours des dix dernières années vers les molécules organiques telles qu'elles ont été répertoriées par exemple dans le livre édité par D.S. Chemla et J. Zyss, Academic Press (1987) "Nonlinear Optical Properties of Organic Molecules and Crystals". Parmi les structures cristallines de ce type, on peut citer :
. le POM (3-méthyl-4-nitropyridine-1-oxyde) (J. Zyss, D.S. Chemla et J.F. Nicoud J. Chem. Phys. **74**, 4800, (1981)),
. le NPP N-(4-nitrophenyl)-L-prolinol) (J. Zyss, J.F. Nicoud et A. Coquillay, J. Chem. Phys. **81**, 4160 (1984)),
. le NPAN (N-(4-nitrophenyl)-N-dimethylamino-aceto-nitrile (P. Vidakovic, M. Coquillay et A. Salin, J. Opt. Soc. Am. **B4**, 998, (1987).

Ces cristaux présentent une non-linéarité exceptionnellement élevée (par exemple d₂₁ de l'ordre de 50 pm/V pour le NPP) au prix toutefois d'une transparence limitée vers la partie bleue du spectre. Par ailleurs, la cohésion et la stabilité à l'air de tels cristaux dans des conditions usuelles d'application peut pour certains d'entre eux présenter des inconvénients : c'est en particulier le cas du POM qui doit être immergé dans un liquide protecteur et présente par ailleurs une tendance marquée à la sublimation.

Il a récemment été proposé par R. Masse et J. Zyss, dans Molecular Engineering **1**, 141, 1991, d'encapsuler des molécules organiques non-linéaires dans un réseau "charpente" constitué d'anions minéraux associés entre eux par liaison hydrogène. L'entité organique est conçue de façon à se greffer, par liaison hydrogène simple ou multiple, aux anions minéraux. Les polyanions proposés sont de type arséniate (H₂AsO₄⁻)ₙ sulfate (HSO₄⁻)ₙ ou phosphate (H₂PO₄⁻)ₙ. Un cristal particulièrement intéressant à été identifié dans cette famille : le 2-amino-5-nitropyridinium dihydrogène monophosphate (2A5NPDP).

Cette structure cristalline, de symétrie ponctuelle mm2 présente une inclinaison de l'ordre de 36° des dipôles de transition de l'entité organique par rapport à l'axe polaire cristallin, ce qui favorise le coefficient d₃₁ (de l'ordre de 10 pm/V) et les effets paramétriques exigeant l'accord de phase par biréfringence (génération de second-harmonique, amplification paramétrique).

Il est néanmoins souhaitable de trouver d'autres structures cristallines où de préférence un coefficient dᵢᵢ (avec i = 1, 2 ou 3) serait optimisé par l'alignement le plus parfait possible des molécules dans la maille le long d'une direction cristallographique i à l'image des cristaux de MNA (2-méthyl-4-nitroaniline) comme ils ont été décrits par G. Lipscomb, A. Garito et R. Narang, J. Chem. Phys. **75**, 1509, (1981) ou des cristaux de DMACB (4,4'-diméthylaminocyanobiphényl) comme ils ont été décrits par J. Zyss, I. Ledoux, M. Bertault, E. Toupet, Chem. Phys. 150, 125, (1991).

On rappelle que les coefficients d₂₁ et d₂₂ se rapportent aux coefficients du tenseur de susceptibilité non-linéaire quadratique, l'axe 2 étant l'axe de symétrie linéaire dans le groupe cristallographique 2 (rotation contrastée).

On signalera, par ailleurs, G.R. Meredith (ACS Symposium Series, **233**, 27-56 (1983)) qui a développé des sels organiques pour l'optique non-linéaire quadratique, dans lesquels des cations, présentant un caractère de transfert de charge intra-moléculaire sont associés à des anions organiques chiraux, achiraux ou minéraux. Les anions utilisés dans cette référence sont des unités indépendantes qui ne s'organisent pas en une structure polyanionique et la cohésion mécanique de telles structures n'est encore pas suffisante.

Au vu de l'art antérieur exposé ci-dessus, un des objets de l'invention est de proposer de nouvelles structures cristallines, présentant des effets non-linéaires quadratiques.

Un second objet de l'invention est de proposer des structures cristallines présentant des effets non-linéaires quadratiques accrus par rapport à ceux de l'art antérieur.

Un autre objet de la présente invention est de proposer des structures cristallines présentant des effets non-linéaires quadratiques et une excellente cohésion des entités moléculaires organiques dans le cristal.

D'autres objets de l'invention apparaîtront à la lecture de la description qui va suivre.

Selon la présente invention, la structure cristalline présentant des effets non-linéaires quadratiques et une plage de transparence large s'étendant du visible au proche infra-rouge est constituée de cations 2-amino-5-nitropyridinium éventuellement substitués associés à une matrice organique polyanionique formée d'anions monohydrogénotartrates gauches ou droits.

Les substituants des cations 2-amino-5-nitropyridinium sont ceux qui ne modifient pas de façon significative l'orientation favorable de l'entité organique polarisable dans la maille cristalline.

Les cristaux de monohydrogénotartrates gauches ou droits sont bien connus et sont notamment décrits dans Chemische Krystallographie P. Groth, vol. 3, page 302 et suivantes (1910) ; Acta Cryst. (1966). **21**, 237-243 et Appl. Cryst. (1979). **12**, 537-544.

Selon une variante préférée, la structure cristalline est caractérisée en ce que le cation répond à la formule suivante : 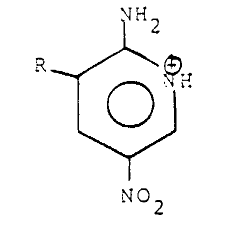 dans laquelle :
R représente un atome d'hydrogène, un radical méthyle ou éthyle, un radical hydroxy.

De préférence encore, le cation est le 2-amino-5-nitropyridinium.

Sans être lié de quelque façon que ce soit à une théorie scientifique, le déposant pense néanmoins que ces structures possèdent une cohésion spécifique due à des liaisons hydrogène courtes des chaînes tartrate entre elles, liaisons qui ne peuvent être rompues par les cations organiques associés.

On retrouve dans ces cristaux la stabilité, la transparence et la facilité de croissance cristalline des sels de l'acide tartrique.

L'invention concerne également un procédé de préparation des structures cristallines telles qu'elles viennent d'être décrites dans la description ci-dessus, caractérisé en ce qu'on mélange une mole de 2-amino-5-nitropyridine éventuellement substitué avec au moins une mole d'acide tartrique gauche et/ou droit dans un solvant approprié, notamment l'eau, en ce que l'on fait cristalliser le mélange avec, dans le cas où l'acide tartrique utilisé est au moins en partie racémique (gauche et droit), séparation des cristaux gauches des cristaux droits, en ce que l'on récupère les structures cristallines.

De préférence, on mélangera une mole de 2-amino-5-nitropyridine éventuellement substitué avec au moins deux moles d'acide tartrique gauche ou droit.

La cristallisation s'effectue dans les mêmes conditions que celle mise en oeuvre pour l'acide tartrique lui-même. Il s'agit donc d'une méthode bien connue de l'homme du métier.

Avantageusement, dans une solution saturée en rotation d'un mélange anions-cations, sera présent un germe cristallin d'une structure cristalline telle que décrite ci-dessus. L'évaporation lente conduit à la cristallisation recherchée, à température constante (ambiante notamment). On peut également abaisser progressivement cette température.

Dans le cas où l'acide tartrique racémique est utilisé, la cristallisation successive conduit aux structures gauches ou droites recherchées.

Dans le cas préféré ou l'on utilise les formes optiquement active de l'acide tartrique, l'obtention de l'acide tartrique gauche ou droit est bien connue de l'homme du métier et résulte d'une séparation par cristallisation successive de l'acide tartrique racémique.

Il est en effet préférable, de combiner des formes préalablement séparées de l'acide tartrique avec la molécule organique. En sélectionnant préalablement au mélange la forme gauche ou droite de l'acide, on évite d'avoir à séparer les deux cristaux ioniques gauches et droites qui résulteraient d'un mélange racémique.

Les monocristaux possèdent les propriétés requises, c'est-à-dire une structure cristalline polaire (groupe spatial P2₁) compatible à la fois avec les exigences de l'optique non-linéaire (effets quadratiques) et de la ferroélectricité, une réponse non-linéaire et un compromis transparence-efficacité satisfaisant.

Ils réalisent par ailleurs un empilement quasi parfait de dipôles organiques parallèlement à l'axe polaire 2₁, dans leur structure, maximisant les valeurs des coefficients r₂₂ et d₂₂ des tenseurs électrooptiques et de génération de second-harmonique, l'axe polaire cristallin étant noté 2.

L'invention concerne un dispositif à effet électrooptique comportant une structure cristalline telle que décrite précédemment. Ces dispositifs génèrent une second-harmonique ou plus généralement une somme ou différence de fréquences. Les applications qui découlent de ces propriétés avantageuses sont nombreuses tant en cristal massif, qu'en structure guidante telles que :
- modulation de phase d'une porteuse optique
- modulation d'amplitude
- coupleur directif,
- croisement électrooptique et plus généralement point de commutation électrooptique,
- échantillonnage électrooptique,
- logique électronique,
- déclenche électrooptique de lasers ("Q-Switch") sans préjudice des applications exigeant un accord de phase par biréfringence telles que :
- génération de second-harmonique,
- conversions de fréquence
- amplification, émission et oscillation paramétriques.

A titre d'exemple, on décrit ci-après une cavité laser à déclenche électrooptique munie d'une structure cristalline selon l'invention.

Dans un tel dispositif, une structure cristalline selon l'invention est introduite dans la cavité d'un laser (par exemple un laser YAG émettant à 1.06 ou 1.34 m et plus généralement tout laser émettant dans la plage de transparence du cristal de 0,45 à 1,7 m) dans une configuration de type cellule de Pockels. Le jeu de polarisations et réflexions aboutit à un blocage de l'émission lorsque le cristal est sous tension. En l'absence de tension, le cristal redevient passant et la cavité peut émettre. Un schéma général de principe est par exemple indiqué dans Hellwarth R.W. "Q Modulation of lasers" dans Lasers, vol. 1, A.K Levine ed. (New York, Marcel Dekker, 1966) p. 253.

L'invention est maintenant illustrée par les exemples de réalisation donnés à titre indicatif :

### Exemple 1

Une mole de 2-amino-5-nitropyridine est dissoute dans une solution d'acide tartrique gauche (50 cm³ H₂O) contenant trois moles d'acide. La dissolution est rapide à 50°C.

La réaction chimique s'écrit :

C₅H₅N₃O₂+L-C₄H₆O₆ C₅H₆N₃O₂⁺ + L-C₄H₅O₆⁻ C₅H₆N₃O₂⁺ .L-C₄H₅O₆⁻

### Exemple 2

On opère de la même façon qu'à l'exemple 1 en remplaçant l'acide tartrique gauche par l'acide tartrique droit.

### Exemple 3

L'acide racémique DL tartrique est mélangé de la même façon que dans l'exemple 1 avec la 2-amino-5-nitropyridine et conduit à la séparation des isomères gauches et droits.

Dans tous les cas, l'évaporation des solutions à température ambiante produit de beaux cristaux de monohydrogénotartrates gauches ou droits de 2-amino-5-nitropyridinium que l'on peut confondre avec des cristaux de l'acide gauche tartrique (ou droit), ayant tous deux la même morphologie, celles des sels de symétrie P2₁ gauches ou droits des acides tartriques.

Des cristaux trapus de 5 mm x 5 mm x 8 mm ont été obtenus aisément. Tous ces cristaux sont jaune clairs, ce qui les distinguent des acides tartriques gauches ou droits.

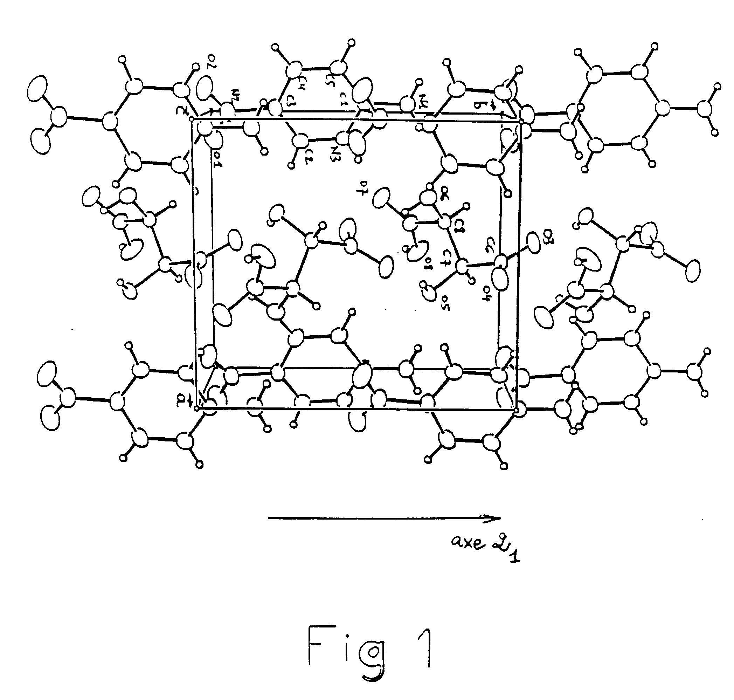

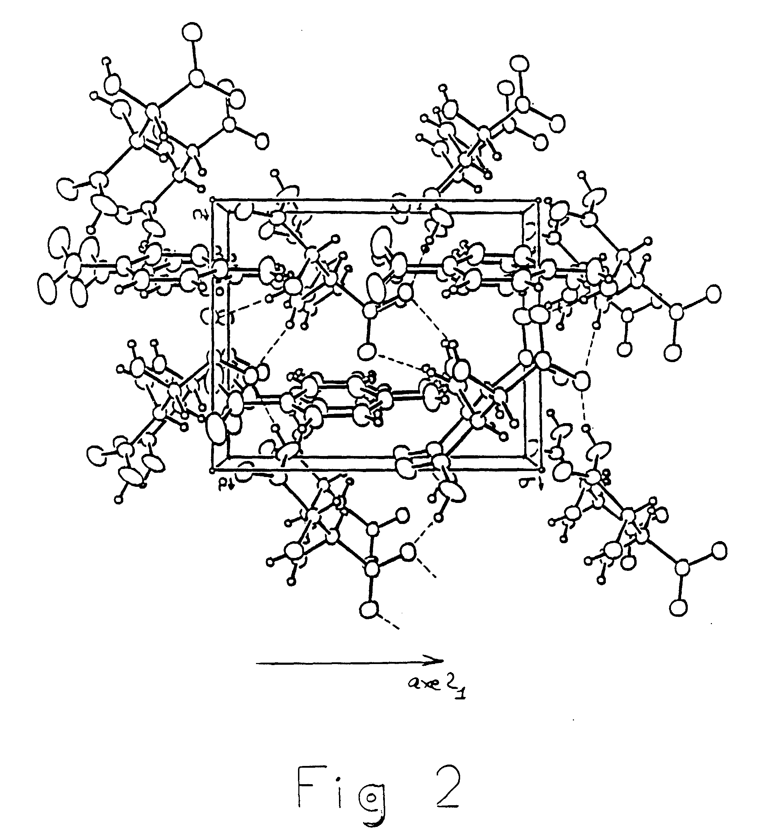

Les figures 1 et 2 annexées illustrent pour les cristaux obtenus selon l'exemple 1 l'alignement parfait des dipoles moléculaires allant du groupe nitro au groupe amino, le long de l'axe cristallographique b, l'axe b est l'axe de symétrie binaire du groupe d'espace p₂₁. L'orientation des dipôles organiques correspond à la maximisation des coefficients d₂₂ (effets de second-harmonique et effets paramétriques) et r₂₂ (effets électrooptiques).

## Revendications

1. Structure cristalline présentant des effets non-linéaires quadratiques et une plage de transparence large s'étendant du visible au proche infra-rouge constituée de cations 2-amino-5-nitropyridinium éventuellement substitués associés à une matrice organique polyanionique, d'anions monohydrogénotartrates gauches ou droits.

2. Structure cristalline selon la revendication 1, caractérisée en ce que le cation répond à la formule suivante : 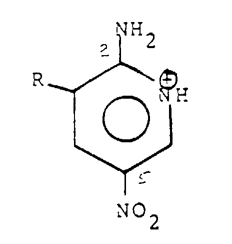 dans laquelle :
R représente un atome d'hydrogène, un radical méthyle ou éthyle, un radical hydroxy.

3. Structure cristalline selon la revendication 2, caractérisée en ce que le cation est le 2-amino-5-nitropyridinium.

4. Procédé de préparation des structures cristallines selon la revendication 1, caractérisé en ce qu'on mélange une mole de 2-amino-5-nitropyridine éventuellement substitué avec au moins un mole d'acide tartrique gauche et/ou droit dans un solvant approprié, notamment l'eau, en ce que l'on fait cristalliser le mélange avec, dans le cas où l'acide tartrique utilisé est au moins en partie racémique (gauche et droit), séparation des cristaux gauches des cristaux droits, en ce que l'on récupère les structures cristallines.

5. Procédé de préparation selon la revendication 4, caractérisé en ce qu'on mélange une mole de 2-amino-5-nitropyridine éventuellement substitué avec au moins deux moles d'acide tartrique gauche et/ou droit.

6. Procédé de préparation selon l'une des revendications 4 ou 5, caractérisé en ce que, dans la solution saturée de mélange, un germe cristallin d'une structure cristalline selon l'une des revendications 1 à 3 est présent et en ce que la cristallisation est effectuée par évaporation du solvant à température effectuée ambiante ou par abaissement progressif de la température.

7. Procédé selon l'une des revendications 4 à 6, caractérisé en ce que l'acide tartrique est une forme gauche ou droite.

8. Dispositif à effet électrooptique comportant une structure cristalline selon l'une des revendications 1 à 3.

9. Dispositif selon la revendication 8, caractérisé en ce qu'il s'agit d'une cavité laser à déclenche électrooptique.

10. Dispositif pour générer une somme ou différence de fréquences, caractérisé en ce qu'il comporte une structure cristalline selon l'une des revendications 1 à 3, notamment un dispositif d'amplification, d'émission et oscillation paramétrique.

## Patentansprüche

1. Kristalline Struktur, die nicht-lineare quadratische Effekte und einen großen Durchlässigkeitsbereich aufweist, der vom Sichtbaren bis zum nahen Infrarot reicht, gebildet aus ggf. substituierten 2-Amino-5-nitropyridinium-Kationen, verbunden mit einer organischen polyanionischen Matrix, wobei die Anionen links- oder rechtsdrehende Monohydrogentartrate sind.

2. Kristalline Struktur nach Anspruch 1, dadurch gekennzeichnet, daß das Kation folgende Formel aufweist: 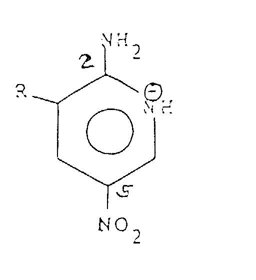 in welcher R für ein Wasserstoffatom, ein Methyl- oder Ethylradikal, ein Hydroxylradikal steht.

3. Kristalline Struktur nach Anspruch 2, dadurch gekennzeichnet, daß das Kation 2-Amino-5-nitropyridinium ist.

4. Verfahren zur Herstellung von kristallinen Strukturen nach Anspruch 1, dadurch gekennzeichnet, daß man ein Mol ggf. substituiertes 2-Amino-5-nitropyridin mit mindestens einem Mol links- und/oder rechtsdrehender Tartratsäure in einem geeigneten Lösungsmittel, im besonderen Wasser, mischt, in welchem man das Gemisch kristallisieren läßt, wenn die Tartratsäure mindestens teilweise als racemisches Gemisch (links- und rechtsdrehend) eingesetzt wird, Trennung der linksdrehenden Kristalle von den rechtsdrehenden Kristallen, wodurch man die kristallinen Strukturen wiedergewinnt.

5. Herstellungsverfahren nach Anspruch 4, dadurch gekennzeichnet, daß man ein Mol ggf. substituiertes 2-Amino-5-nitropyridin mit mindestens zwei Mol links- und/oder rechtsdrehender Tartratsäure mischt.

6. Herstellungsverfahren nach Anspruch 4 oder 5, dadurch gekennzeichnet, daß, in der gesättigten Lösung des Gemisches, ein Kristallkeim einer kristallinen Struktur nach einem der Ansprüche 1 bis 3 vorliegt und daß die Kristallisation durch Verdampfung des Lösungsmittels bei Raumtemperatur oder durch zunehmende Absenkung der Temperatur durchgeführt wird.

7. Verfahren nach einem der Ansprüche 4 bis 6, dadurch gekennzeichnet, daß die Tartratsäure in links- oder rechtsdrehender Form vorliegt.

8. Vorrichtung mit elektro-optischem Effekt, die eine kristalline Struktur nach einem der Ansprüche 1 bis 3 aufweist.

9. Vorrichtung nach Anspruch 8, dadurch gekennzeichnet, daß es sich um eine Laserkavität mit elektro-optischer Auslösung handelt.

10. Vorrichtung zur Erzeugung einer Summe oder einer Differenz von Frequenzen, dadurch gekennzeichnet, daß sie eine kristalline Struktur nach einem der Ansprüche 1 bis 3 umfaßt, insbesondere eine Vorrichtung zur parametrischen Amplifikation, Emission und Oszillation.

## Claims

1. Crystalline structure exhibiting nonlinear quadratic effects and a wide transparency range extending from the visible to the near infrared, consisting of optionally substituted 2-amino-5-nitropyridinium cations combined with a polyanionic organic matrix of left-handed or right-handed monohydrogentartrate anions.

2. Crystalline structure according to Claim 1, characterized in that the cation corresponds to the following formula: 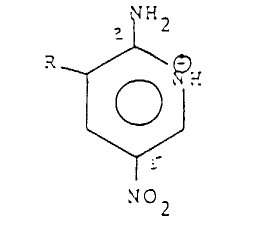 in which:
R represents a hydrogen atom, a methyl or ethyl radical or a hydroxyl radical.

3. Crystalline structure according to Claim 2, characterized in that the cation is 2-amino-5-nitropyridinium.

4. Process for the preparation of the crystalline structures according to Claim 1, characterized in that one mole of optionally substituted 2-amino-5-nitropyridine is mixed with at least one mole of left-handed and/or right-handed tartaric acid in a suitable solvent, especially water, in that the mixture is crystallized with, in the case where the tartaric acid used is at least partly racemic (left-handed and right-handed), separation of the left-handed crystals from the right-handed crystals, and in that the crystalline structures are recovered.

5. Preparation process according to Claim 4, characterized in that one mole of optionally substituted 2-amino-5-nitropyridine is mixed with at least two moles of left-handed and/or right-handed tartaric acid.

6. Preparation process according to either of Claims 4 or 5, characterized in that, in the saturated solution of mixture, a crystalline seed of a crystalline structure according to one of Claims 1 to 3 is present and in that crystallization is carried out by evaporation of the solvent at a temperature made ambient or by progressive lowering of the temperature.

7. Process according to one of Claims 4 to 6, characterized in that the tartaric acid is a left-handed or right-handed form.

8. Device having an electooptical effect containing a crystalline structure according to one of Claims 1 to 3.

9. Device according to Claim 8, characterized in that it is a laser cavity having electrooptical triggering.

10. Device for generating a frequency sum or difference, characterized in that it contains a crystalline structure according to one of Claims 1 to 3, especially a device for parametric amplification, emission and oscillation.
